(19) Europäisches Patentamt
European Patent Office
Office européen des brevets

(11) Publication number : **0 421 686 B1**

(12) # EUROPEAN PATENT SPECIFICATION

(45) Date of publication of patent specification : **24.08.94 Bulletin 94/34**

(51) Int. Cl.$^5$ : **H01J 37/32,** H01J 9/14, H01L 21/302

(21) Application number : **90310656.5**

(22) Date of filing : **28.09.90**

(54) **Electrode plate for plasma etching.**

(30) Priority : **02.10.89 JP 258057/89**

(43) Date of publication of application : **10.04.91 Bulletin 91/15**

(45) Publication of the grant of the patent : **24.08.94 Bulletin 94/34**

(84) Designated Contracting States : **DE FR GB NL**

(56) References cited :
**EP-A- 0 064 163**
**PATENT ABSTRACTS OF JAPAN vol. 12, no. 127 (E-602)(2974) 20 April 1988, & JP-A-62 252942**

(73) Proprietor : **TOKAI CARBON CO. LTD.**
**2-3 Kita-Aoyama, 1-chome**
**Minato-ku Tokyo (JP)**

(72) Inventor : **Itoh, Hajime**
**1-34-1-402 Hibarigaoka**
**Chigasaki-shi, Kanagawa-ken (JP)**

(74) Representative : **Miller, Joseph et al**
**J. MILLER & CO.**
**34 Bedford Row,**
**Holborn**
**London WC1R 4JH (GB)**

EP 0 421 686 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to an electrode plate used for plasma etching of a wafer in producing a semiconductor integrated circuit.

In recent years, there is an ever-increasing demand for an increase in the fineness and density of a semiconductor integrated circuit. With the increase in the above-described demand, a parallel flat plate plasma etching technique has become more and more important because it can afford a fine pattern with a high accuracy.

The parallel flat plate plasma etching is a method which comprises applying a high frequency power across a pair of upper and lower smooth plate electrodes provided opposite to each other to generate plasma, thereby forming a predetermined pattern on a wafer placed on the lower electrode through etching. In the above-described plasma etching, free radicals and ions of a halogenated reactant gas present in the plasma are attracted by an electric field present in the electrode and perpendicularly impinge against the wafer placed on the lower electrode to thereby etch a portion free from a photoresist.

A material for the electrode used in the above-described plasma etching is required to have various characteristics such as high purity and chemical stability as well as conductivity, and metallic plates and high-density graphite plates have hitherto been used as the electrode.

The metallic electrode plates, however, had drawbacks that the chemical stability is unsatisfactory and it is very difficult to increase the purity of the material.

On the other hand, the high-density graphite electrode plate inherently has excellent conductivity and chemical stability and further has an advantage that the purity can easily be increased. However, since this electrode plate has a structure comprising a cluster of particles, the fine particles constituting the structure will fall off as separate particles during the generation of plasma, which brings about problems such as accelerated consumption of the electrode plate and staining of the upper face of the wafer.

The present inventor previously proposed an electrode plate made of a high-purity glassy carbon for the purpose of eliminating excessive consumption of the electrode plate due to the occurrence of separate particles in using such a high-density graphite electrode (see Japanese patent application Kokai publication No. 62-252942).

The plasma etching electrode plate made of the glassy carbon has a homogeneous and dense structure of a three-dimensional network structure quite different from the cluster of particles found in the high density graphite material. Further, it has conductivity and chemical stability characteristic of a carbonaceous material, and its purity can easily be increased. Therefore, the practical performance of the above-described electrode plate is superior to that of the conventional metallic and high-density graphite electrode plates.

However, closed fine bubbles are contained in the glassy carbon material structure, and minute carbides produced through carbonization of less volatile components in a starting resin during production of an electrode plate are present in free form inside the bubbles. This free carbide tends to fall off in the form of separate particles as the electrode is consumed during plasma etching.

Further, the above-described material has a problem that the extent of consumption of the surface of the electrode plate varies depending upon the size of the bubbles contained in the structure, which spoils the uniformity of the etching.

Meanwhile, as the demand on the plasma etching increases, the electrode plate for plasma etching should satisfy higher performance requirements. Specifically, it should satisfy such performance requirements that the number of separate particles (the number of particles having a size of 0.3 μm or more which fall on the surface of a 15 cm (6-inch) wafer during one etching period) should be 30 or less and the variation in the rate of etching should be in the range of ± 3 %. For this reason, the electrode plate comprising a glassy carbon material having the conventional structure has come to fail in sufficiently satisfying the performance requirements.

An object of the present invention is to provide an electrode plate for plasma etching which satisfies performance requirements for an electrode for plasma etchng, i.e., requirements that the number of separate particles (the number of particles having a size of 0.3 μm or more which fall on the surface of a 15 cm (6-inch) wafer during one etching period) should be 30 or less and the variation in the rate of etching should be in the range of ± 3 %.

The above-described object of the present invention is attained by an electrode for plasma etching comprising a high-purity glassy carbon having a maxium pore diameter of 1 μm or less, an average pore diameter of 0.7 μm or less and a porosity of 1 % or less.

In the electrode plate for plasma etching of the present invention (hereinafter referred to merely as electrode plate), there is no particular limitation on the maximum pore diameter as far as it is 1 μm or less, though it is preferably 0.02 to 1 μm.

In the electrode plate of the present invention, the average pore diameter is 0.7 μm or less, preferably 0.01

to 0.7 μm.

Further, in the electrode plate of the present invention, the porosity is 1 % or less, preferably 0.04 to 1 %.

The electrode plate of the present invention comprises a glassy carbon. The term "glassy carbon" used herein is intended to mean one characterized by high hardness and gas impermeability and generally prepared by the carbonization of a thermosetting resin such as a phenolic resin or a furan resin, sugar, cellulose or polyvinylidene chloride. The glassy carbon has a conchoidal pattern in its fracture like usual glasses, no black carbon powder adheres when touched with fingers, and a mirror finish surface can be attained by polishing.

The pore characteristics of the electrode plate of the present invention, i.e., maximum pore diameter, average pore diameter and porosity, suggest that it has much more homogeneous and dense structure than that of the electrode comprising the conventional glassy carbon.

A process for producing the electrode plate of the present invention will now be described.

Examples of the starting material include a furan resin, a phenolic resin and a mixture thereof. These resins are subjected to cast molding, inmold molding or injection molding to give a flat plate molding. The molding is then cured at 50 to 90° C in the case of the furan resin and at 150 to 190° C in the case of the phenolic resin. The obtained resin plate is then fired in an inert atmosphere at about 1000° C for carbonization. The temperature is further raised to about 2000° C, and the plate is maintained in a chlorine gas atmosphere for a suitable length of time for an increase in the purity and heat treatment. For example, in the case of the furan resin, an electrode plate of a glassy carbon having a predetermined shape can be produced by adding a curing catalyst to a precondensate, subjecting the mixture to cast molding to give a cured molding, firing the cured molding and heat-treating the fired molding.

In general, glassy carbon has open and closed micropores in its structure.

These pores are formed when the precondensate of the resin is cured further by polycondensation because part of the water formed by condensation and the decomposition gas will remain in the cured molding, since they are difficult to completely remove from the molding, and disperse into the texture of the carbonaceous material during firing.

Therefore, in order to prevent the formation of the pores, it is necessary to remove the water formed by condensation and the decomposition gas by curing the molding as gradually as possible. For this reason, 1 to 3 % by weight of such as trichloroacetic, trifluoroacetic or picric acid, based on the amount of the resin, is added.

The curing is conducted at a lowest possible temperature for a longest possible period of time. The molding is maintained at three temperature stages, e.g., 50, 70 and 90° C, each for a long period of time to moderately advance the polycondensation, thereby gradually curing the molding. Subsequently, the cured molding is fabricated into a predetermined shape, fired in an inert atmosphere and heat treated. The firing is conducted for example by heating the molding at a tempreraturе rise rate of 50° C/hr and maintaining the molding at 900 to 1100° C for a predetermined period of time. The resultant fired, carbonized molding is heat-treated at about 2000° C for a suitable length of time while flowing a chlorine gas.

This heat treatment causes metallic impurities to be removed through vaporization in the form of a chloride, so that an electrode plate having a high purity can be produced.

As described above, the electrode plate for plasma etching according to the present invention has inherently excellent conductivity and chemical stability because it is made of a glassy carbon material.

Further, the specified pore characteristics of an average pore diameter of 0.7 μm or less and a porosity of 1 % or less effectively function for suppressing the number of separate particles in one etching period to 30 or less, while the specified pore characteristics of a maximum pore diameter of 1 μm or less and a porosity of 1 % or less contribute to maintaining the uniformity of the etching rate within ± 3 % by uniforming the consumption of the electrode surface.

The above-described functions are combined with each other to make it possible to conduct stable plasma etching over a long period of time without staining the wafer.

Methods of measuring pore characteristics in the present invention will now be described.

A. Maximum pore diameter:

A sample is cut and the section thereof is subjected to mirror polishing and observed under an optical microscope (x 100) and a scanning electron microscope (SEM)(x 2000) to measure a pore diameter per unit area for 10 fields of view of each microscope, thereby determining the maximum pore diameter.

B. Average pore diameter:

The average pore diameter is an average value of pore diameters measured by the above method A.

C. Porosity:

A round rod sample having a diameter of 50 mm and a length of 230 mm is maintained in an air bath at 105 to 110° C for 2 hr. The sample is cooled to room temperature in a desiccator, and the mass of the sample is immediately measured. Thereafter, the sample is again transferred into the air bath and again cooled to room temperature in the desiccator one hour after the transfer into the air bath, and the mass of the sample is measured. This procedure is repeated until the mass of the sample becomes constant.

Then, the length and diameter of the sample are measured at four points, and the volume of the sample is calculated from the average length and the average diameter.

The bulk specific gravity is determined by the following equation:

$$d_b = \frac{m}{v}$$

wherein

db : bulk specific gravity;

m : mass of dried sample (g); and

v : volume ($cm^3$).

Then, the whole of the above-described sample was crushed, and the obtained grains were sufficiently mixed and further pulverized in a mortar until the whole can pass through a 149-µm wire sieve.

The mass of a preliminarily sufficiently dried specific gravity bottle equipped with a side tube and having an internal volume of about 40 mℓ is accurately measured. Then, a sample (dried at 105 to 110° C for about 2 hr and then cooled to room temperature in a desiccator) is placed at the bottom of the bottle evenly in a thickness of about 10 mm (corresponding to a weight of 7 to 12 g), and the mass of the sample is accurately measured.

1-Butanol specified in JIS K 8810, which has been maintained under a reduced pressure of 2.0 to 2.7 kPa (15 to 20 mmHg) for 20 min or longer, is gently added to the bottle at a height of about 20 mm from the bottom, and the bottle is softly vibrated. After recognizing that the occurrence of large bubbles has ceased, the bottle is placed in a vacuum desiccator and gradually evacuated to 2.0 to 2.7 kPa (15 to 20 mmHg). The bottle is maintained under that presure for 20 min or longer, taken out of the desiccator after the occurrence of bubbles has ceased, filled with 1-butanol, stoppered and immersed in a thermostatted water bath (adjusted to 30 ± 0.03° C) for 15 min or longer, and the liquid surface of 1-butanol is allowed to coincide with the marked line. Then the bottle is taken out of the bath and its outside is well wiped. After the bottle is cooled to room temperature, its mass is accurately measured and the bottle is again placed in a thermostatted water bath. The same procedure is repeated four times to determine the average value.

Thereafter, the same specific gravity bottle is filled with only 1-butanol and immersed in a thermostatted water bath in the same manner as that described above. The liquid surface is allowed to coincide with the marked line, and the mass of the bottle is measured. This procedure is repeated four times to determine the average value.

Distilled water from which gas dissolved therein has been removed by boiling immediately before use, is placed in a specific gravity bottle, and the bottle is immersed in a thermostatted water bath in the same manner as that described above. The liquid surface is allowed to coincide with the marked line, and the mass of the bottle is measured. This procedure is repeated four times to determine the average value.

The true specific gravity of the sample is calculated by the following equation and rounded off to three decimals:

$$d_t = \frac{m_2 - m_1}{m2 - m_1 - (m_4 - m_3)} x \frac{m_3 - m_1}{m_5 - m_1} d$$

wherein

$d_t$ : true specific gravity;

$m_1$ : mass of the specific gravity bottle (g);

$m_2$ : mass of the specific gravity bottle charged with a sample (g);

$m_3$ : mass of the specific gravity bottle charged with only 1-butanol to the marked line (g);

$m_4$ : mass of the specific gravity bottle charged with a sample and further 1-butanol to the marked line (g);

$m_5$ : mass of the specific gravity bottle charged with only distilled water to the marked line (g); and

d : specific gravity of water (0.9946 at 30° C).

Finally, the porosity is calculated by the following equation.

$$p (\%) = \frac{d_t - d_b}{d_t} x 100$$

wherein

p : porosity;

$d_t$ : true specific gravity; and

$d_b$ : bulk specific gravity.

The present invention will now be described in more detail by way of the following Examples.

Examples 1 to 4 and Comparative Examples 1 to 3:

A solution of one part by weight of powdery trichloroacetic acid in three parts by weight of ethyl alcohol was mixed with a liquid furan resin (Hitaran VF-303, a product of Hitachi Chemical Co., Ltd., Japan) in varied proportions.

The resultant mixtures were each poured into a mold to mold them into flat plates. The furan resin was cured by maintaining the mixture at 50, 70 and 90° C each for a predetermined length of time. The cured flat plates were fired for carbonization under varied conditions. Specifically, the flat plates were heated to a temperature ranging from 900 to 1100° C in an oven at a temperature rise rate of 2 to 10° C/hr, maintained at that temperature for a predetermined period of time and then heated to a temperature ranging from 1900 to 2100° C at a temperature rise rate of 50 to 100° C/hr and maintained at that temperature for a predetermined period of time.

Further, the flat plates were maintained at 2000° C while flowing a chlorine gas to remove impurities and effect purification.

Thus, 3 mm-thick glassy carbon plates having different pore characteristics were produced under varied conditions of the amount of the curing catalyst and firing for carbonization.

Small holes each having a diameter of 0.8 mm were formed by electric discharge machining at equal intervals of 3 mm on the surface of each flat plate, and the flat plates were then purified with a chlorine gas. The amount of the impurities was 3 ppm or less in all of the glassy carbon plates after the purification.

The above-described high-purity glassy carbon plates were set as an electrode in a parallel flat plate plasma etching device, and a silicon wafer oxide film was etched under the conditions of the use of trifluoromethane ($CHF_3$) as a reactant gas, a gas pressure in the reaction chamber of 6.65 Pa (0.05 Torr) and a power source frequency of 380 kHz.

The performance of each electrode plate was determined, and the results are given in Table 1 in comparison with the pore characteristics.

In the electrode performance given in Table 1, the number of separate particles is expressed in terms of the number of carbon particles having a size of 0.3 μm or more fallen on the surface of a 15 cm-wafer (6″-wafer) during one etching period and the uniformity is expressed in terms of the percentage variation (%) based on the etching rate of 70 μm/min (7000 Å/min), while the surface roughness is expressed in terms of the surface roughness of the portion consumed by electric discharge.

The number of separate particles, uniformity and surface roughness were measured by the following methods.

Number of separate particles:

The number of separat particles present on the wafer was counted by making use of a Surface Contamination Analyzer (Surfscan 4500, a produce of TENCOR Instruments Co.). The use of this instrument enables the surface of the wafer to be scanned by means of a helium-neon laser beam and the real number of particles to be counted while excluding the duplicate counting of the particles.

Uniformity:

The thickness of the thin film on the surface of wafer subjected to the etching treatment was measured by making use of lambda Å STM-603-PS (an optical film thickness meter, a product of DAINIHON SCREEN Manufacturing Co.), and the variations in the thickness were determined.

Surface roughness:

It was measured by making use of a surface roughness measuring instrument (Model SE-3C) manufactured by Kosaka Research Co.

From the results given in Table 1, it is apparent that the Examples 1 to 4 satisfy the characteristics requirements specified in the present invention, i.e., the number of separate particles of 30 or less and a uniformity of ± 3% or less, as opposed to Comparative Examples 1 to 3 which are outside the characteristics requirements specified in the present invention.

As described above, the electrode plate for plasma etching of the present invention comprises a glassy carbon structure having specific pore characteristics. As a result, a remarkable decrease in the number of separate particles and uniform consumption of the surface of the electrode plate in the etching step have become possible.

Therefore, the use of the electrode plate of the present invention enables strict performance requirements in recent years to be satisfied and stable etching to be conducted in any time without any trouble.

Table 1

| Ex. No. | Pore Characteristics | | | Electrode Performance | | | | | |
|---|---|---|---|---|---|---|---|---|---|
| | Maximum Pore Diameter (µm) | Average Pore Diameter (µm) | Porosity (%) | Number of Separate Particles | Uniformity (± %) | Surface Roughness (µm) | Hardness (H) | Bending Strength (kg/cm²) | Specific Electric Resistance ($\times 10^{-4}$ Ωcm) |
| Ex. 1 | 1.0 | 0.7 | 1.0 | 29 | 3 | 4 | 123 | 1320 | 43 |
| Ex. 2 | 0.4 | 0.25 | 0.5 | 10 | 3 | 4 | 125 | 1370 | 43 |
| Ex. 3 | 0.1 | 0.06 | 0.2 | 3 | 2 | 3 | 125 | 1410 | 43 |
| Ex. 4 | 0.03 | 0.02 | 0.07 | 1 | 2 | 3 | 125 | 1500 | 43 |
| Comp. Ex. 1 | 27 | 8 | 4.6 | 170 | 10 | 18 | 77 | 1050 | 45 |
| Comp. Ex. 2 | 10 | 4.5 | 3.0 | 98 | 5 | 9 | 121 | 1140 | 43 |
| Comp. Ex. 3 | 35 | 2.3 | 2.0 | 56 | 4 | 9 | 123 | 1270 | 44 |

## Claims

1. An electrode plate for plasma etching made of a high-purity glassy carbon having a maximum pore diameter of 1 μm or less, an average pore diameter of 0.7 μm or less and a porosity of 1% or less.

2. An electrode plate according to claim 1, wherein said high-purity glassy carbon has a maximum pore diameter of 0.02 to 1 μm, an average pore diameter of 0.01 to 0.7 μm and a porosity of 0.04 to 1 %.

## Patentansprüche

1. Elektrodenplatte zum Plasmaätzen aus einem glasartigen Kohlenstoff hoher Reinheit mit einem maximalen Porendurchmesser von 1 μm oder weniger, einem mittleren Porendurchmesser von 0,7 μm oder weniger und einer Porosität von 1 % oder weniger.

2. Elektrodenplatte nach Anspruch 1, bei der der glasartige Kohlenstoff hoher Reinheit einen maximalen Porendurchmesser von 0,02 bis 1 μm, einen mittleren Porendurchmesser von 0,01 bis 0,7 μm und eine Porosität von 0,04 bis 1 % hat.

## Revendications

1. Plaque d'électrode pour gravure par plasma constituée d'un carbone vitreux de haute pureté ayant un diamètre de pore maximal de 1 μm ou moins, un diamètre de pore moyen de 0,7 μm ou moins, et une porosité de 1% ou moins.

2. Plaque d'électrode selon la revendication 1, dans laquelle ledit carbone vitreux de haute pureté a un diamètre de pore maximal de 0,02 à 1μm, un diamètre de pore moyen de 0,01 à 0,7 μm et une porosité de 0,04 à 1%.